Europäisches Patentamt

European Patent Office

Office européen des brevets

(19)

(11) Numéro de publication : **0 050 583**
**B1**

# (12) FASCICULE DE BREVET EUROPÉEN

(45) Date de publication du fascicule du brevet :
04.07.84

(21) Numéro de dépôt : **81810349.1**

(22) Date de dépôt : **27.08.81**

(51) Int. Cl.³ : **G 04 C   1/00, H 03 L   5/00**

(54) Convertisseur d'une tension alternative en un courant continu et circuit d'oscillateur comportant ce convertisseur.

(30) Priorité : **16.10.80 CH 7730/80**

(43) Date de publication de la demande :
**28.04.82 Bulletin 82/17**

(45) Mention de la délivrance du brevet :
**04.07.84 Bulletin 84/27**

(84) Etats contractants désignés :
**DE FR GB**

(56) Documents cités :
**US-A- 3 763 444**
**LES ACTES DU DIXIEME CONGRES INTERNATIO-**
**NAL DE CHRONOMETRIE, vol. 3, septembre 1979,**
**GENEVE (CH) E.A. VITTOZ: "Quartz Oscillators for**
**Watches" pages 131-140**

(73) Titulaire : **EBAUCHES ELECTRONIQUES S.A.**
**CH-2074 Marin (CH)**

(72) Inventeur : **Leuthold, Oskar**
**Kellerweg 53**
**CH-3249 Tschugg (CH)**

(74) Mandataire : **Dronne, Guy et al**
**Ebauches S.A. 1, Faubourg de l'Hôpital**
**CH-2001 Neuchâtel (CH)**

Jouve, 18, rue St-Denis, 75001 Paris, France

## Description

La présente invention concerne un convertisseur d'une tension alternative en un courant continu, du type comportant des bornes d'alimentation, une borne d'entrée et une borne de sortie.

L'invention concerne aussi un circuit d'oscillateur faisant application de ce convertisseur.

L'invention concerne, plus particulièrement, les oscillateurs à très faible consommation de courant qui sont utilisés dans les montres.

Dans de tels oscillateurs, un circuit régulateur maintient l'amplitude du signal d'oscillation à une valeur faible, afin de minimiser la consommation de courant de cet oscillateur. L'amplitude du signal d'oscillation doit toutefois être suffisante pour permettre l'utilisation de ce signal dans des circuits suivants tels que : amplificateurs, diviseur de fréquence, etc.

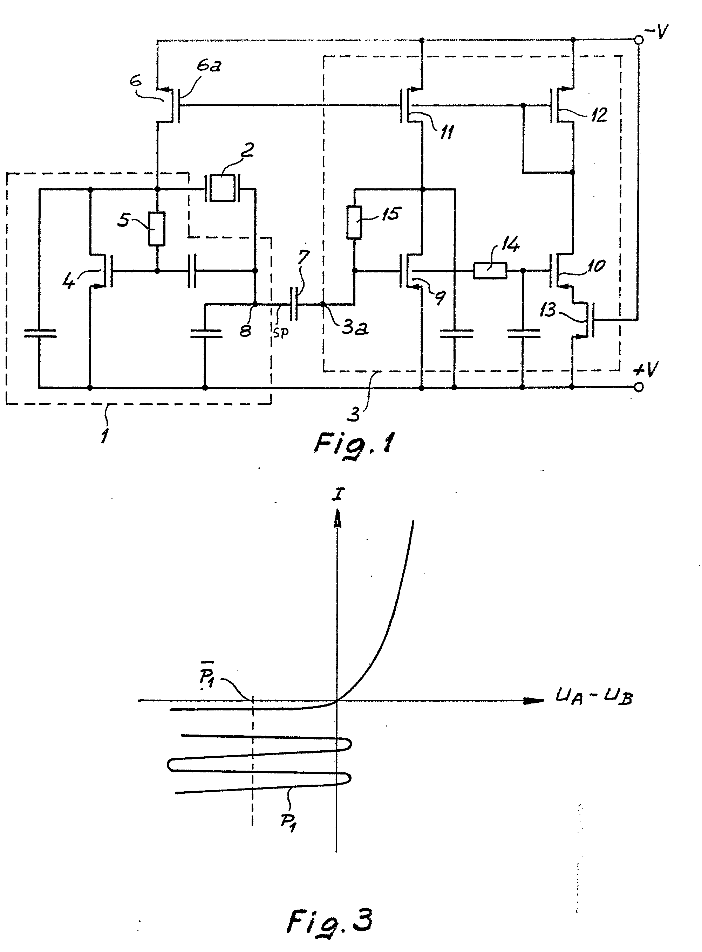

Dans l'article de E. A. VITTOZ « Quartz oscillators for watches » publié dans les actes du dixième Congrès International de Chronométrie, Genève, Septembre 1979, volume 3, pages 131-140, on décrit un circuit d'oscillateur du type susmentionné. Ce circuit connu, qui est représenté sur la figure 1, comprend un circuit d'entretien 1 des vibrations d'un résonateur à quartz 2, et un régulateur d'amplitude 3. Le circuit d'entretien 1 comporte un transistor MOS amplificateur 4 polarisé par une résistance 5 ; le trajet drain-source du transistor 4 est branché en série avec celui d'un autre transistor MOS 6, entre les bornes + V et − V d'une source de tension d'alimentation. Le transistor 6 joue le rôle d'une source de courant réglable alimentant le transistor amplificateur 4 du circuit d'entretien 1. La borne de commande de la source de courant 6, qui est la grille 6a de ce transistor 6, reçoit un signal de commande fourni par le circuit régulateur 3 qui reçoit lui-même sur son entrée 3a *via* un condensateur de découplage 7, un signal d'oscillation de l'oscillateur, signal présent sur une borne d'entrée 8 du circuit d'oscillateur. Le circuit régulateur 3 comprend quatre transistors MOS 9 à 12 connectés deux à deux en miroirs et formant une boucle fermée dont le gain est limité par une résistance constituée par un cinquième transistor 13. Le circuit régulateur 3 et le transistor 6 constituent ensemble un convertisseur d'une tension alternative d'entrée en un courant continu. Ce convertisseur connu, de par sa conception, nécessite un réseau de polarisation des transistors comportant des résistances 14, 15 de très haute valeur constituées par des diodes réalisées dans le silicium polycristallin. Il en résulte que ce circuit connu ne peut être réalisé que dans une technologie dans laquelle les grilles des transistors MOS sont réalisées en silicium polycristallin fortement dopé.

C'est pourquoi la présente invention a notamment pour objet de proposer un convertisseur d'une tension alternative en un courant continu, pouvant être réalisé dans n'importe quelle technologie.

Ce but est atteint conformément à l'invention du fait que le convertisseur selon le préambule de la revendication 1 comprend un premier convertisseur élémentaire fournissant en réponse à une tension alternative d'entrée, un courant continu pulsé $i_1$ dont la valeur moyenne $\bar{i}_1$ est une fonction fortement croissante de l'amplitude A de ladite tension alternative, et un second convertisseur élémentaire fournissant, en réponse au courant $i_1$, le courant $i_3$ dont la valeur est une fonction fortement décroissante de $\bar{i}_1$, fonction telle que l'on ait, dans un certain domaine de valeurs de A, sensiblement :

$$i_3 = C_1(A_M - A),$$

où $C_1$ est un paramètre constant et $A_M$ une valeur particulière de A située dans ledit domaine de valeurs.

Avantageusement, le premier convertisseur élémentaire est agencé pour fournir un courant $\bar{i}_1$ tel que $\bar{i}_1 = i_{10}$ exp A/Uc où $i_{10}$ et Uc sont des paramètres constants,

et le second convertisseur élémentaire est agencé pour fournir un courant $i_3$ tel que $i_3 = i_{30} - C_1$ ln $(\bar{i}_1)$ où $i_{30}$ est une constante.

Il en résulte que l'on a :

$$i_3 = i_{30} - C_2 \text{ A/Uc}$$

où $C_2$ est une constante.

Cette valeur de $i_3$ est donc bien une fonction décroissant linéairement en A.

Les caractéristiques respectivement exponentielles et logarithmiques de ces convertisseurs élémentaires peuvent chacune être obtenues en première approximation au moyen de transistors MOS travaillant sensiblement en faible inversion, sans nécessiter l'utilisation de résistances de haute valeur. Il est en effet bien connu qu'un transistor MOS auquel on applique une tension de polarisation grille-source dont la valeur est inférieure à celle du seuil théorique, ce transistor fournit sur son trajet drain-source un courant dont la valeur est une fonction exponentielle de celle de ladite tension de polarisation.

Selon un mode de réalisation particulier, le premier convertisseur élémentaire comprend un premier transistor MOS dont la grille est connectée à la borne d'entrée du convertisseur par l'intermédiaire d'un condensateur de découplage, et des moyens de polarisation de ce premier transistor. Ces moyens de polarisation comprennent avantageusement un circuit répondant à la tension alternative d'entrée pour appliquer entre la grille et la source de ce transistor MOS une tension de polarisation dont la valeur moyenne est une fonction sensiblement linéaire de l'amplitude A de la tension alternative.

Ce circuit répondant à la tension alternative d'entrée comprend avantageusement : un deuxième transistor MOS dont l'une des bornes de canal est connectée à la grille du premier transistor, et un circuit de polarisation de ce deuxième transistor, agencé pour appliquer entre la deuxième borne de canal et la grille du deuxième transistor, une tension constante choisie pour que l'impédance de ce deuxième transistor soit élevée.

Selon un exemple de réalisation de l'invention, le second convertisseur élémentaire comprend un troisième, un quatrième et un cinquième transistor MOS, des moyens répondant au courant $i_2$ circulant dans le quatrième transistor pour appliquer entre la grille et la source du troisième transistor une tension de commande qui est une fonction linéaire de la valeur moyenne dudit courant circulant dans le quatrième transistor, cette tension de commande étant telle que le troisième transistor fonctionne toujours en faible inversion, les quatrième et cinquième transistors ayant leurs grilles connectées ensemble et leurs sources connectées à une même borne d'alimentation, le drain du cinquième transistor étant relié à la borne de sortie du convertisseur, et des moyens répondant au courant $i_1$ fourni par le premier convertisseur pour appliquer sur le quatrième transistor une tension de polarisation grille-source telle que la valeur moyenne du courant dans le troisième transistor soit égale à la valeur moyenne $\overline{i}_1$ du courant $i_1$.

Selon un mode particulier de réalisation du second convertisseur élémentaire, les drains des premier et troisième transistors sont connectés entre eux ainsi qu'à la grille du quatrième transistor et à une armature d'un condensateur (faisant partie des moyens répondant au courant $i_1$) dont l'autre armature est reliée à une première borne d'alimentation, la grille du troisième transistor reçoit un potentiel constant tandis que la source dudit troisième transistor est connectée au drain du quatrième transistor et à une borne d'une résistance (faisant partie des moyens répondant au courant $i_2$) dont l'autre borne est reliée à la deuxième borne d'alimentation, la source du quatrième transistor étant reliée à ladite première borne d'alimentation, les composants du convertisseur étant dimensionnés de façon que le courant traversant le quatrième transistor soit généralement grand vis-à-vis de celui qui circule dans le troisième transistor.

Ce convertisseur est avantageusement utilisé dans un circuit d'oscillateur comprenant : une première et une deuxième borne d'alimentation, un circuit d'entretien comportant une borne d'entrée, une borne de sortie, une première et une deuxième borne pour le branchement d'un résonateur, au moins un élément actif amplificateur et des moyens de polarisation de cet élément actif, ce circuit d'oscillation étant caractérisé en ce qu'il comprend en outre un convertisseur tel que décrit ci-dessus comportant une borne d'entrée et une borne de sortie, la borne d'entrée dudit convertisseur étant branchée à la borne d'entrée ou à la borne de sortie du circuit d'entretien, la borne de sortie dudit convertisseur étant branchée sur le trajet de courant de l'élément actif.

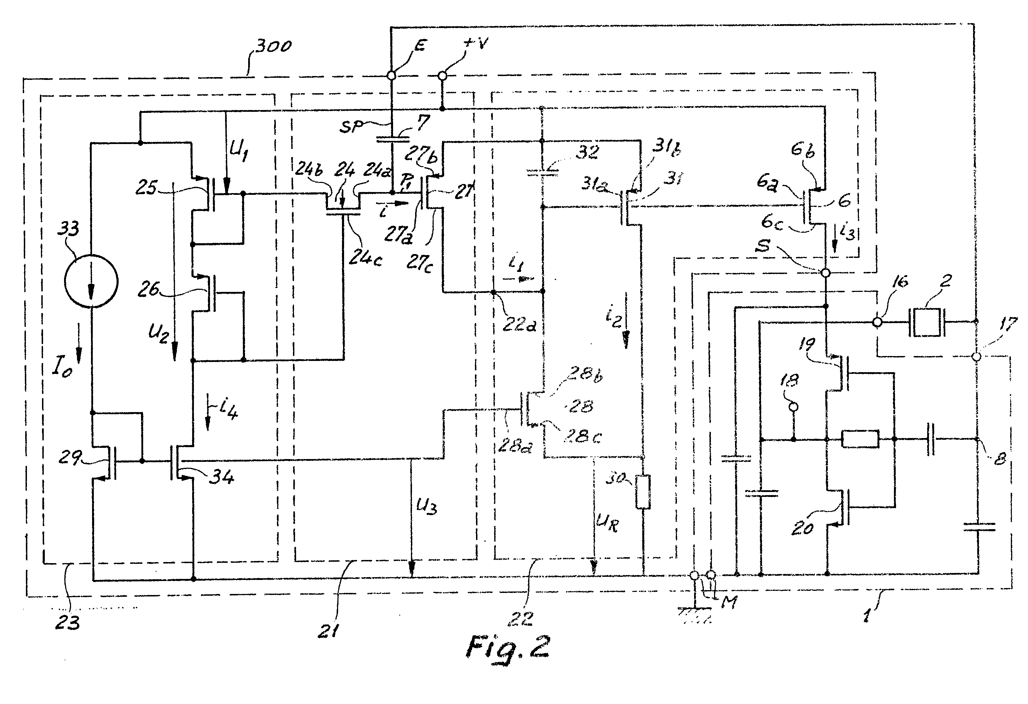

Les caractéristiques et avantages de l'invention seront mieux compris à la lecture de la description qui va suivre d'un mode de réalisation de l'invention, description faite en référence aux figures 2 et 3 des dessins annexés dans lesquels :

la figure 1 déjà décrite représente le schéma électrique d'un circuit d'oscillateur selon un art antérieur ;

la figure 2 est le schéma électrique d'un circuit d'oscillateur selon un mode de réalisation de l'invention ; et

la figure 3 représente le diagramme du courant drain-source d'un transistor du premier convertisseur en fonction de la différence de potentiel existant entre les deux électrodes de canal de ce transistor.

Sur la figure 2, les éléments analogues à ceux du circuit de la figure 1 sont repérés par les mêmes références. Comme le circuit de la figure 1, le circuit de la figure 2 comporte une première + V et une deuxième M borne d'alimentation, un circuit d'entretien 1 comprenant des bornes 16 et 17 pour le branchement d'un résonateur 2, une borne d'entrée 8 et une borne de sortie 18. Le circuit d'entretien représenté sur la figure 2 comporte deux transistors MOS complémentaires branchés en inverseur 19 et 20. Ce type de circuit à inverseur étant bien connu en soi, il ne sera pas davantage décrit ici.

Tout comme dans le circuit de la figure 1, une source de courant réalisée sous la forme d'un transistor MOS 6 est branchée en série avec les trajets drain-source des éléments actifs 19, 20. La borne de commande (grille 6a) de la source de courant 6 reçoit un signal de commande fourni par un circuit régulateur formant avec la source de courant 6 un convertisseur 300 d'une tension alternative d'entrée SP en un courant continu $i_3$, convertisseur dont la structure diffère fondamentalement de celle du convertisseur représenté sur la figure 1.

Comme le montre la figure 2, le convertisseur 300 comprend trois parties : une partie convertisseur tension-courant 21, une partie convertisseur courant-courant 22, et un circuit de polarisation 23.

La partie 21 comprend un transistor MOS 24 dont une borne de canal 24a reçoit, via un condensateur 7, le signal d'oscillation SP ou signal de pilotage présent sur la borne d'entrée 8 du circuit d'entretien 1. L'autre borne de canal 24b reçoit un potentiel constant $U_1$ fourni par le circuit de polarisation 23, et la grille 24c du transistor 24 reçoit un potentiel constant $U_2$ fourni par le circuit de polarisation 23. La tension $U_1$ est fournie par un transistor MOS à canal P 25 dont la grille est connectée au drain et dont la source est reliée à la borne + V. Le potentiel $U_2$ est, en valeur absolue, supérieur au potentiel $U_1$ d'environ une valeur de tension de seuil. Ce potentiel $U_2$ est fourni par un second transistor MOS à canal P 26 dont la grille est connectée au drain, et dont la source est connectée au drain du transistor 25.

Au repos, le signal SP est nul et le transistor à canal P 24 est commandé par une tension grille-source qui est de l'ordre de grandeur de celle d'une tension de seuil, de sorte que ce transistor 24 se comportera comme une résistance de haute valeur parcourue par un très faible courant. Lorsque l'oscillateur oscille, le signal SP est différent de zéro et le fonctionnement du transistor 24 sera différent suivant le signe du signal SP qui lui est appliqué sur sa borne de canal 24a. Sur le diagramme de la figure 3, on a porté en abscisse la différence de potentiel entre le potentiel $U_A$ de la borne 24a et le potentiel $U_B$ de la borne 24b du transistor 24. En ordonnée du diagramme de la figure 3, on a représenté le courant I circulant dans le trajet drain-source du transistor 24.

Le fonctionnement du transistor 24 est le suivant : durant les alternances négatives du signal SP, la borne 24a est négative par rapport à la borne 24b, de sorte que le transistor 24 est parcouru par un faible courant sensiblement indépendant de la valeur du potentiel de la borne 24a. Durant les alternances positives du signal SP, la borne 24a devient positive par rapport à la borne 24b, de sorte que le courant i parcourant le transistor 24 augmente exponentiellement en fonction du potentiel de la borne 24a. Cependant en raison de la présence du condensateur 7, la charge ∫idt durant une alternance négative doit être égale à la charge durant une alternance positive du signal SP. Il en résulte que la borne 24a ne devient positive par rapport à la borne 24b que pendant un temps très court coïncidant avec les pointes positives du signal SP. Durant ce temps, le potentiel de la borne 24a reste voisin de celui de la borne 24b, c'est-à-dire que le potentiel de la borne 24a reste voisin de la valeur $U_1$. Ainsi, le signal de tension $P_1$ présent sur la borne 24a et représenté sur la figure 3 présente une valeur moyenne $\bar{P}_1$ dont la valeur est une fonction sensiblement linéaire de l'amplitude A du signal SP.

Le signal $P_1$ est appliqué sur la grille 27a d'un transistor à canal P 27 dont la source 27b est reliée à la borne d'alimentation + V, et dont le drain 27c est relié à la borne d'entrée 22a du circuit convertisseur courant-courant 22. Le transistor 27 délivre au convertisseur 22 un courant continu pulsé $i_1$ dont la valeur moyenne $\bar{i}_1$ est fortement dépendante de l'amplitude A du signal alternatif d'entrée SP.

En raison de la caractéristique non linéaire du transistor 27, le courant $i_1$ qu'il fournit croît comme une fonction exponentielle avec la valeur absolue du signal de tension $P_1$ appliqué sur sa grille 27a. En effet, même si la valeur moyenne $\bar{P}_1$ du signal de tension $P_1$ reste constante, l'augmentation du courant $i_1$ durant l'alternance négative du signal SP dépasse fortement la réduction de courant $i_1$ pendant l'alternance positive de ce signal SP. Vu que, cependant, la tension moyenne $\bar{P}_1$ diminue également avec l'amplitude A du signal SP, le courant $i_1$ augmente considérablement en fonction de cette amplitude A.

Le rôle du convertisseur courant-courant est de fournir, en réponse au courant $i_1$ fourni par le transistor 27, un courant $i_3$ dont la valeur est une fonction décroissante de $\bar{i}_1$. De plus, $i_3$ doit devenir nul pour une valeur donnée $A_M$ de l'amplitude du signal d'entrée SP et il doit, dans un large domaine voisin de zéro, diminuer à peu près linéairement en fonction de l'amplitude A du signal d'entrée SP.

Il est à noter que le régulateur d'amplitude 300 est utilisé dans un système bouclé qui ne doit pas être nécessairement stable. Dans cet ensemble, il est souhaitable que la fonction de transfert du circuit régulateur soit bien définie et reste reproductible malgré l'influence des paramètres de procédé de fabrication du circuit.

Le convertisseur courant-courant 22 comprend un transistor MOS à canal N 28 ; la grille 28a du transistor 28 reçoit un potentiel constant $U_3$ fourni par un transistor MOS à canal N 29 dont la grille est connectée au drain et dont la source est connectée à la borne d'alimentation M. Le drain 28b du transistor 28 est relié à l'entrée 22a du convertisseur 22. Le transistor 28 est donc commandé par une tension $U_R$ appliquée sur sa source 28c.

Comme cela est connu, lorsque le transistor 28 travaille en faible inversion, il existe une dépendance exponentielle entre le courant circulant dans ce transistor 28 et la tension de commande $U_R$ de ce transistor. La tension $U_R$ est produite par la chute de tension due à la circulation d'un courant $i_2$ dans une résistance 30, le courant $i_2$ étant fourni par un transistor MOS à canal P 31 dont le trajet drain-source est branché en série avec la résistance 30 entre les bornes d'alimentation + V et M.

La grille 31a du transistor 31 est connectée à l'entrée 22a du convertisseur 22, ainsi qu'à une armature d'un condensateur 32 dont l'autre armature est connectée à la borne d'alimentation + V. Le rôle du condensateur 32 est de maintenir à peu près constante pendant une période du signal d'entrée SP, la tension de la grille 31a et donc la tension du drain 28b du transistor 28.

Les composants du circuit 300 sont dimensionnés de telle sorte que le courant circulant dans le transistor 28 peut généralement être considéré comme négligeable par rapport au courant circulant dans le transistor 31.

Les transistors 28 et 31 forment un système bouclé à contre-réaction dont le fonctionnement est le suivant :

Un courant $i_1$ infecté sur l'entrée 22a du convertisseur 22 décharge le condensateur 32 de sorte que le potentiel de la borne 22a croît et le courant circulant dans le transistor 31 décroît. En conséquence, la tension de commande $U_R$ devient plus faible, de sorte que le courant dans le transistor 28 augmente, ce qui a pour effet que, à l'état d'équilibre du circuit, le courant circulant dans le transistor 28 est égal au courant injecté $i_1$ sur la borne 22a.

En raison de la caractéristique non linéaire du transistor 28, pour une augmentation exponentielle du courant $i_1$ alimenté, la tension de commande $U_R$ doit diminuer de façon linéaire, ce qui signifie que le courant circulant dans le transistor 31 diminue également de façon linéaire.

Vu que le courant $i_1$ fourni par le transistor 27 croît lui aussi comme une fonction exponentielle de l'amplitude A du signal d'entrée SP, il résulte que le courant $i_2$ fourni par le transistor 31 diminue à peu près linéairement en fonction de l'amplitude A croissante du signal SP.

Le transistor 6 peut être dimensionné par rapport au transistor 31 de manière à fournir un courant $i_3$ convenable pour commander le circuit d'entretien 1.

Les transistors 25, 26 et 29 fournissant les tensions constantes $U_1$, $U_2$ et $U_3$ font partie du circuit de polarisation 23 qui comprend en outre : une source de courant 33 branchée en série, entre les bornes d'alimentation + V et M, avec le trajet drain-source du transistor 29, et un quatrième transistor 34 à canal N, dont le trajet drain-source est branché entre la borne d'alimentation M et le drain du transistor 26.

Il est avantageux de réaliser le circuit 300 de la manière suivante :

Les transistors 28, 29 et 34 ont même géométrie et le transistor 25 est n fois plus large que le transistor 27. Dans ce cas, on démontre que, lorsque A = 0, on a :

$$i_1 = i_{10} = i_4/n = I_0/n$$

où $I_0$ est le courant fourni par la source 33 et $i_4$ est le courant circulant dans les transistors 25, 26 et 34.

Typiquement, $\bar{i}_1$ est multiplié par 100 quand A varie de 0 à 400 mV ; il en résulte que n = 100, $A_M$ étant égal à 400 mV.

Les sources 6b et 31b des transistors 6 et 31 sont connectées à la borne d'alimentation + V tandis que le drain 6c du transistor 6 est connecté à la borne de sortie S du convertisseur 300. Le transistor 6 est à canal P.

Par un dimensionnement convenable de la résistance 30 et du transistor 6, on peut régler le courant de démarrage $i_{30}$ fourni par le transistor 6 à la valeur désirée.

Il faut noter que la valeur $I_0$ du courant fourni par la source de courant 33 du circuit de polarisation 23 ne joue aucun rôle tant que les transistors 28 et 29 et 34 travaillent en faible inversion. Ce courant $I_0$ n'a donc pas besoin d'être stabilisé par exemple vis-à-vis des fluctuations de la tension d'alimentation fournie par les bornes + V, M. Les tensions de seuil des transistors n'interviennent pas non plus. Seul intervient dans la fonction de transfert du convertisseur 300 la transconductance des transistors 24 et 27 ; cette transconductance est cependant une caractéristique présentant une bonne reproductibilité qui est en tout cas suffisante pour l'application envisagée ici.

## Revendications

1. Convertisseur d'une tension alternative (SP) en un courant continu $i_3$, du type comprenant une première (+ V) et une deuxième (M) borne d'alimentation, une borne d'entrée (E) et une borne de sortie (S), caractérisé en ce qu'il comprend un premier convertisseur élémentaire (21) fournissant en réponse à la tension alternative (SP) un courant continu pulsé ($i_1$) dont la valeur moyenne ($\bar{i}_1$) est une fonction fortement croissante de l'amplitude A de ladite tension alternative (SP), et un second convertisseur élémentaire (22) fournissant en réponse au courant ($i_1$) fourni par le premier convertisseur élémentaire le courant continu $i_3$ dont la valeur est une fonction fortement décroissante de la valeur moyenne ($\bar{i}_1$) du courant ($i_1$) fourni par le premier convertisseur élémentaire telle que l'on ait dans un certain domaine de valeurs de A, sensiblement :

$$i_3 = C_1(A_M - A)$$

où $C_1$ est un paramètre constant et $A_M$ une valeur particulière de A dans ledit domaine de valeurs.

2. Convertisseur selon la revendication 1, caractérisé en ce que le premier convertisseur élémentaire (21) comprend un premier transistor MOS (27) dont la grille (27a) est connectée à la borne d'entrée (E) du convertisseur par l'intermédiaire d'un condensateur de découplage (7), et des moyens de polarisation (24, 25, 26) de ce premier transistor.

3. Convertisseur selon la revendication 2, caractérisé en ce que lesdits moyens de polarisation comprennent un circuit (24, 25, 26) répondant à la tension alternative (SP) pour appliquer entre la grille (27a) et la source (27b) du premier transistor (27) une tension de polarisation dont la valeur moyenne est une fonction sensiblement linéaire de l'amplitude (A) de la tension alternative (SP).

4. Convertisseur selon la revendication 3, caractérisé en ce que ledit circuit répondant à la tension alternative (SP) comprend : un deuxième transistor MOS (24) dont l'une (24a) des bornes de canal est connectée à la grille (27a) du premier transistor (27), et un circuit de polarisation (25, 26) de ce deuxième transistor (24) agencé pour appliquer entre la deuxième borne de canal (24b) et la grille (24c) du deuxième transistor (24) une tension constante ($U_2$-$U_1$) choisie pour que l'impédance dudit deuxième transistor soit élevée.

5. Convertisseur selon l'une des revendications 1 à 4, caractérisé en ce que le second convertisseur élémentaire (22) comprend : un troisième (28), un quatrième (31) et un cinquième (6) transistor MOS, des moyens répondant au courant ($i_2$) circulant dans le quatrième transistor (31) pour appliquer entre la grille (28a) et la source (28c) du troisième transistor (28) une tension de commande ($U_3$-$U_R$) qui est une fonc-

tion linéaire dudit courant ($i_2$) circulant dans le quatrième transistor (31), les quatrième et cinquième transistors ayant leurs grilles (31a, 6a) connectées ensemble et leurs sources connectées à la première borne d'alimentation (+ V), le drain du cinquième transistor (6) étant relié à la borne de sortie (S) du convertisseur, et des moyens répondant au courant ($i_1$) fourni par le premier convertisseur élémentaire (21) pour appliquer sur le quatrième transistor (31) une tension de polarisation grille-source telle que la valeur moyenne du courant circulant dans le troisième transistor (28) soit égale à la valeur moyenne ($\bar{i}_1$) du courant ($i_1$) fourni par le premier convertisseur élémentaire.

6. Convertisseur selon la revendication 5, caractérisé en ce que les drains (27a), (28b) des premier (27) et troisième transistors (28) sont connectés entre eux ainsi qu'à la grille (31a) du quatrième transistor (31) et à une armature d'un condensateur (32) faisant partie des moyens répondant au courant ($i_1$) fourni par le premier convertisseur élémentaire (21), l'autre armature du condensateur étant reliée à ladite première borne d'alimentation (+ V) et en ce que la grille (28a) du troisième transistor (28) reçoit un potentiel constant ($U_3$) tandis que la source (28c) dudit troisième transistor (28) est connectée au drain du quatrième transistor (31) et à une borne d'une résistance (30) faisant partie des moyens répondant au courant ($i_2$) circulant dans le quatrième transistor (31), l'autre borne de la résistance étant reliée à la deuxième borne d'alimentation (M), la source du quatrième transistor (31) étant reliée à ladite première borne d'alimentation (+ V).

7. Circuit d'oscillateur comprenant une première (+ V) et une deuxième (M) borne d'alimentation, un circuit d'entretien (1), comportant une borne d'entrée (8), une borne de sortie (18), une première (16) et une deuxième (17) borne pour le branchement d'un résonateur (2), au moins un élément actif amplificateur (19, 20) et des moyens de polarisation de cet élément actif, caractérisé en ce qu'il comprend en outre un convertisseur (300) selon l'une des revendications précédentes comportant une borne d'entrée (E) et une borne de sortie (S), la borne d'entrée (E) dudit convertisseur étant branchée à la borne d'entrée (8) ou à la borne de sortie (18) du circuit d'entretien (1), la borne de sortie (S) dudit convertisseur étant branchée sur le trajet de courant de l'élément actif (19, 20).

## Claims

1. A converter for converting an alternating voltage (SP) into a direct current $i_3$, of the type comprising first (+ V) and second (M) supply terminals, an input terminal (E) and an output terminal (S), characterized in that it comprises a first elementary converter (21) which supplies, in response to the alternating voltage (SP), a pulsed direct current ($i_1$) having a mean value ($\bar{i}_1$) which is a sharply increasing function of the amplitude A of said alternating voltage (SP), and a second elementary converter (22) which supplies, in response to the current ($i_1$) supplied by the first elementary converter, the direct current $i_3$ whose value is a sharply decreasing function of the mean value ($\bar{i}_1$) of the current ($i_1$) supplied by the first elementary converter such as to have within a certain range of values of A, substantially :

$$i_3 = C_1(A_M - A)$$

where $C_1$ is a constant parameter and $A_M$ is a particular value of A within said range of values.

2. A converter as in claim 1, characterized in that the first elementary converter (21) comprises a first MOS transistor (27) whose gate (27a) is connected to the input terminal (E) of the converter via a decoupling capacitor (7), and means (24, 25, 26) for biasing said first transistor.

3. A converter as in claim 2, characterized in that said biasing means comprise a circuit (24, 25, 26), responsive to the alternating voltage (SP), for applying between the gate (27a) and the source (27b) of the first transistor (27) a biasing voltage having a mean value which is a substantially linear function of the amplitude A of the alternating voltage (SP).

4. A converter as in claim 3, characterized in that the circuit which responds to the alternating voltage (SP) comprises : a second MOS transistor (24) having a first channel terminal (24a) connected to the gate (27a) of the first transistor (27), and a circuit (25, 26) for biasing said second transistor (24) adapted to apply between a second channel terminal (24b) and the gate of the second transistor (24) a constant voltage ($U_2$-$U_1$) such that the impedance of said second transistor is high.

5. A converter as in any of claims 1 to 4, characterized in that the second elementary converter (22) comprises : third (28), fourth (31) and fifth (6) MOS transistors, means responsive to the current ($i_2$) flowing in the fourth transistor (31) to apply between the gate (28a) and the source (28c) of the third transistor (28) a control voltage ($U_3$-$U_R$) which is a linear function of said current ($i_2$) flowing in the fourth transistor (31), the fourth and fifth transistors having their gates (31a, 6a) connected to each other and their sources connected to the first supply terminal (+ V), the drain of the fifth transistor (6) being connected to the output terminal (S) of the converter, and means responsive to the current ($i_1$) supplied by the first elementary converter (21) for applying to the fourth transistor (31) a gate-source biasing voltage such that the mean value of the current flowing in the third transistor (28) is equal to the mean value ($\bar{i}_1$) of the current ($i_1$) supplied by the first elementary converter.

6. A converter as in claim 5, characterized in that the drains (27a, 28b) of the first (27) and third (28) transistors are connected to each other and to the gate (31a) of the fourth transistor (31) and to one plate of a capacitor (32) forming part of the means responsive to the current ($i_1$) supplied by

the first elementary converter (21), the other plate of the capacitor being connected to said first supply terminal (+ V), and in that the gate (28a) of the third transistor (28) receives a constant potential (U_3) whilst the source (28c) of the third transistor (28) is connected to the drain of the fourth transistor (31) and to one terminal of a resistor (30) forming part of the means responsive to the current (i_2) flowing in the fourth transistor (31), the other terminal of the resistor being connected to the second supply terminal (M), the source of the fourth transistor (31) being connected to said first supply terminal (+ V).

7. An oscillator circuit comprising first (+ V) and second (M) supply terminals, a maintaining circuit (1) including an input terminal (8), an output terminal (18), first (16) and second (17) terminals for the connection thereto of a resonator (2), at least one active amplifying element (19, 20) and means for biasing said active element, characterized in that it further comprises a converter (300) as in any preceding claim, having an input terminal (E) and an output terminal (S), the input terminal (E) of said converter being connected to the input terminal (8) or to the output terminal (18) of the maintaining circuit (1), the output terminal (S) of said converter being connected to the flow path of the active element (19, 20).

**Ansprüche**

1. Umsetzer zum Umsetzen einer Wechselspannung (SP) in einen Gleichstrom $i_3$ mit einer ersten (+ V) und einer weiten (M) Speisequelle, einer Eingangsklemme (E) und einer Ausgangsklemme (S), dadurch gekennzeichnet, daß er einen ersten Elementarumsetzer (21) umfaßt, der in Abhängigkeit von der Wechselspannung (SP) einen pulsierenden Gleichstrom $i_1$ liefert, dessen Mittelwert ($\overline{i}_1$) eine stark ansteigende Funktion der Amplitude A der Wechselspannung (SP) ist und einen zweiten Elementarumsetzer (22) umfaßt, der in Abhängigkeit von dem Strom ($i_1$), geliefert von dem ersten Elementarumsetzer, den Gleichstrom $i_3$ liefert, dessen Wert eine stark abfallende Funktion des Mittelwertes ($\overline{i}_1$) des Stromes ($i_1$) ist, geliefert von dem ersten Elementarumsetzer derart, daß man in einem bestimmten Wertebereich von A im wesentlichen erhält :

$$i_3 = C_1(A_m - A)$$

worin $C_1$ ein konstanter Parameter ist und $A_M$ ein bestimmter Wert von A in dem genannten Wertebereich.

2. Umsetzer nach Anspruch 1, dadurch gekennzeichnet, daß der erste Elementarumsetzer (21) einen ersten MOS-Transistor (27) umfaßt, dessen Gitter (27a) an die Eingangsklemme (E) des Umsetzers über einen Entkopplungskondensator (7) angeschlossen ist, sowie Mittel (24, 25, 26) zum Polarisieren dieses ersten Transistors umfaßt.

3. Umsetzer nach Anspruch 2, dadurch gekennzeichnet, daß die Mittel zum Polarisieren einen auf die Wechselspannung (SP) ansprechenden Schaltkreis (24, 25, 26) umfaßt zum Anlegen einer Polarisationsspannung zwischen das Gitter (27a) und die Source-Elektrode (27b) des ersten Transistors (27), welche Polarisationsspannung einen Mittelwert aufweist, der eine im wesentlichen lineare Funktion der Amplitude (A) der Wechselspannung (SP) ist.

4. Umsetzer nach Anspruch 3, dadurch gekennzeichnet, daß der auf die Wechselspannung (SP) ansprechende Schaltkreis umfaßt : Einen zweiten MOS-Transistor (24), dessen eine Klemme (24a) des Kanals mit dem Gitter (27a) des ersten Transistors (27) verbunden ist sowie einen Polarisationsschaltkreis (25, 26) dieses zweiten Transistors (24) umfaßt, ausgebildet zum Anlegen einer Konstantspannung ($U_2$-$U_1$), die gewählt ist zum Erhöhen der Impedanz des zweiten Transistors, zwischen die zweite Klemme des Kanals (24b) und das Gitter (24c) des zweiten Transistors (24).

5. Umsetzer nach einem der Ansprüche 1 bis 4, dadurch gekennzeichnet, daß der zweite Elementarumsetzer (22) umfaßt : einen dritten (28), einen vierten (31) und einen fünften (6) MOS-Transistor, auf den im vierten Transistor (31) zirkulierenden Strom ($i_2$) ansprechende Mittel zum Anlegen einer Steuerspannung ($U_3$-$U_R$) zwischen das Gitter (28a) und die Source-Elektrode (28c) des dritten Transistors (28), welche Steuerspannung eine lineare Funktion des in dem vierten Transistor (31) fließenden Stromes ($i_2$) ist, wobei die Gitter (31a, 6a) des vierten und fünften Transistors miteinander verbunden sind und ihre Source-Elektroden an die erste Speisequelle (+V) angeschlossen sind, während die Drain-Elektrode des fünften Transistors (6) an die Ausgangsquelle (S) des Umsetzers angeschlossen ist und auf den vom ersten Elementarumsetzer (21) gelieferten Strom ($i_1$) ansprechende Mittel zum Anlegen einer Gitter-Source-Polarisationsspannung an den vierten Transistor (31) derart, daß der Mittelwert des im dritten Transistors (28) fließenden Stromes gleich dem Mittelwert ($\overline{i}_1$) des Stromes ($i_1$) ist, der vom ersten Elementarumsetzer geliefert wird.

6. Umsetzer nach Anspruch 5, dadurch gekennzeichnet, daß die Drain-Elektroden (27a, 28b) des ersten (27) und dritten Transistors (28) miteinander sowie mit dem Gitter (31a) des vierten Transistors (31) verbunden sind sowie mit einem Belag eines Kondensators (32), der einen Teil der auf den vom ersten Elementarumsetzer (21) gelieferten Strom ($i_1$) ansprechende Mittel bildet, während der andere Belag des Kondensators mit der ersten Speiseklemme (+ V) verbunden ist und daß das Gitter (28a) des vierten Transistors (28) ein Konstantpotential ($U_3$) erhält, während die Source-Elektrode (28b) des dritten Transistors (28) mit der Drain-Elektrode des vierten Transistors (31) verbunden ist sowie mit einer Klemme eines Widerstandes (30), der einen Teil der auf den im vierten Transistor (31) flie-

ßenden Stromes (i$_2$) ansprechende Mittel bildet, während die andere Klemme des Widerstandes mit der zweiten Speiseklemme (M) verbunden ist, wobei die Source-Elektrode des vierten Transistors (31) mit der ersten Speiseklemme (+ V) verbunden ist.

7. Oszillatorkreis mit einer ersten (+ V) und einer zweiten (M) Speisequelle, mit einem Antriebsschaltkreis (1), umfassend eine Eingangsklemme (8), eine Ausgangklemme (18), eine erste (16) und eine zweite (17) Klemme zum Anschließen eines Resonators (2), mindestens ein aktives Verstärkerelement (19, 20) sowie Mittel für die Polarisation dieses aktiven Elementes, dadurch gekennzeichnet, daß er darüberhinaus einen Umsetzer (300) gemäß einem der vorangehenden Ansprüche umfaßt, mit einer Eingangsklemme (E) und einer Ausgangsklemme (S), wobei die Eingangsklemme (E) des Umsetzers an die Eingangsklemme (8) oder die Ausgangsklemme (18) des Antriebschaltkreises (1) angeschlossen ist, während die Ausgangklemme (S) des Umsetzers an den Strompfad des aktiven Elementes (19, 20) angeschlossen ist.

8

Fig.1

Fig.3

Fig.2